(19) Europäisches Patentamt
European Patent Office
Office européen des brevets

(11) EP 1 111 772 B1

(12) EUROPEAN PATENT SPECIFICATION

(45) Date of publication and mention of the grant of the patent:
**25.07.2007 Bulletin 2007/30**

(51) Int Cl.:
***H03D 7/14*** *(2006.01)* ***H04B 1/10*** *(2006.01)*

(21) Application number: **99403243.1**

(22) Date of filing: **21.12.1999**

(54) **Method and apparatus providing improved intermodulation distortion protection**

Verfahren und Vorrichtung zum verbesserten Schutz gegen der Intermodulationsverzerrung

Procede et dispositif ameliorant la protection contre la distorsion d'intermodulation

(84) Designated Contracting States:
**DE FR GB IT**

(43) Date of publication of application:
**27.06.2001 Bulletin 2001/26**

(73) Proprietor: **Freescale Semiconductor, Inc.**
**Austin,**
**Texas 78735 (US)**

(72) Inventors:
- **Khlat, Nadim**
  **31270 Cugnaux (FR)**
- **Hietala, Alex**
  **Phoenix,**
  **Arizona 85048 (US)**
- **Lorenzo-Luaces, Eddie**
  **31300 Toulouse (FR)**

(74) Representative: **Wharmby, Martin Angus**
**Freescale Semiconductor Inc.**
**c/o Impetus IP Limited**
**Grove House**
**Lutyens Close**
**Basingstoke, Hampshire RG24 8AG (GB)**

(56) References cited:
**WO-A-96/01006**
**WO-A-96/25790**
**US-A- 5 115 202**

EP 1 111 772 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

### TECHNICAL FIELD

This invention relates in general to wireless or wireline communication devices and the systems upon which they operate. More generally, the present invention relates to a method and apparatus providing second order intermodulation distortion (IM2) protection for receivers and particularly direct conversion and/or Zero-IF receivers.

### BACKGROUND OF THE INVENTION

In direct conversion and zero-IF receivers, it is necessary to maintain the spectral purity of the channel used for reception. Because of limited narrow band selectivity, second order intermodulation distortion (IM2) presents an undesired spectral component within the signal band of interest. This occurs when two or more interfering signals, whose difference in frequency is less than the IF bandwidth of the desired signal, mix with one another due to some second order nonlinearity and produce a baseband spectral component. To minimize the effects of second order intermodulation within critical circuit blocks in the signal path, it is known in the art to use differential circuits. intermodulation within critical circuit blocks in the signal path, it is known in the art to use differential circuits. In theory, differential circuits have infinite attenuation to second order intermodulation distortion. In reality, this is far from the truth; due, in no small part, to device mismatches, parametric imbalance, imperfect layout, and other device characteristic inequalities that cause imbalances and provides a lower than desired second order input intercept point (IIP2). As will be appreciated by those skilled in the art, the best IIP2 achieved to date in the integrated mixer art is somewhere in the neighborhood of +67 dBm. For several high performance applications, this rejection rate falls nearly 13 dB short of system requirements.

International Patent Application WO 96 01006 A in the name of Honeywell Inc. discloses, in general, a mixer circuit that receives a spread spectrum signal.

It would be extremely advantageous, therefore, to provide a method and apparatus providing improved second order intermodulation distortion performance. This object is achieved by the method defined in Claim 1 and the mixer circuit defined in Claim 5. It would be of greater advantage to apply this methodology to wireless and wireline communications, devices that employ mixer circuits, switches, and other components that exhibit parametric mismatch or imbalance.

### BRIEF DESCRIPTION OF THE DRAWINGS

The features of the present invention, which are believed to be novel, are set forth with particularly in the appended claims. The invention, together with further objects and advantages thereof, may best be understood by reference to the following description, taken in conjunction with the accompanying drawings, in the several figures in which like reference numerals identify like elements, and in which:

FIG. 1 is a differential RF mixer circuit as known in the art;
FIG. 2 is a first embodiment of a differential RF mixer circuit employing dynamic matching in accordance with the present invention;
FIG. 3 is a graph comparing the IM2 performance of the mixers of FIGs. 1 and 2;
FIG. 4 is a second embodiment of a differential RF mixer circuit employing dynamic matching in accordance with the present invention;
FIG. 5 is an embodiment of an RF mixer circuit employing spreading to achieve dynamic matching in accordance with the present invention;
FIG. 6 is a timing diagram for use in association with the device of FIG. 5;
FIG. 7 is an active harmonic mixer employing dynamic matching in accordance with the present invention;
FIG. 8 is a single-balanced mixer employing dynamic matching in accordance with the present invention;
FIG. 9 is a first embodiment of a CMOS down conversion mixer employing dynamic matching in accordance with the present invention;
FIG. 10 is a second embodiment of a CMOS down conversion mixer employing dynamic matching; and
FIG. 11 is a timing diagram for use in association with the devices of FIGs. 9 and 10.
FIG. 12 generally depicts a block diagram of a circuit used to generate a spreading clock in accordance with the invention.
FIG. 13 generally depicts a signal capable of performing complex spreading in accordance with the invention.

## DETAILED DESCRIPTION OF THE PREFERRED EMBODIMENT

While the specification concludes with claims defining the features of the invention that are regarded as novel, it is believed that the invention will be better understood from a consideration of the following description in conjunction with the drawing figures, in which like reference numerals are carried forward.

The present invention has applications for both wireless and wireline communication devices, such as, for example, modems, cellular and PCS phones, two-way radios, pagers and the like. By way of example and not by way of limitation, the following description is applied primarily to mixer circuits and particularly to radio frequency (RF) mixer circuits.

As will be appreciated by those skilled in the art, a mixer is essentially a nonlinear circuit and may be characterized by the following equation:

$$V_{out} = a_1 \bullet (V_{lo} \bullet V_{rf}) + a_2 \bullet (V_{lo} \bullet V_{rf})^2 + a_3 \bullet (V_{lo} \bullet V_{rf})^3 \qquad (1)$$

Second order intermodulation originates from the second term in Equation 1, when two interfering signals mix with each other through a second order nonlinearity to produce an intermodulation product at the sum and difference frequencies of the two interferers. In an ideal differential mixer, coefficient $a_2$ is zero, resulting in no intermodulation distortion. In reality, however, imbalances within a differential mixer, typically caused by mismatches in mixer device characteristics, imperfect layout, and other static imbalances, causes coefficient $a_2$ to be a small, fixed constant. This results in a finite amount of intermodulation distortion. To reduce the amount of intermodulation distortion, dynamic matching is utilized. In accordance with the present invention, dynamic matching transforms coefficient $a_2$ from a fixed constant into a function of time.

$$a_2 \rightarrow f(t)$$

Depending on the choice of $f$(t), the IM2 distortion generated by the second term in Equation 1 can be:

1) translated up in frequency where it can be attenuated by filtering, or
2) spread over a range of frequencies such that the contribution of IM2 within the signal band of interest is insignificant.

To fully understand the mechanism by which dynamic matching works, the following mathematical description is given where $f$(t) is chosen to be a tone signal defined as $\cos\omega_x t$, thereby letting

$$V_{rf} = E_1 \bullet \cos\omega_1 t + E_1 \bullet \cos\omega_2 t \qquad (2)$$

$$V_{lo} = E_2 \bullet \cos\omega_{lo} t \qquad (3)$$

and substituting into the second term of Equation 1 yields the following second order intermodulation terms

$$a_2 \cdot \frac{(E_1 \cdot E_2)^2}{2} \cdot [\cos(\omega_1 + \omega_2)t + \cos(\omega_1 - \omega_2)t] \qquad (4)$$

Choosing $a_2 = \cos\omega_x t$, substituting it into Equation 4 yields:

IM2 Distortion Components:

$$\cos\omega_x t\cdot\frac{(E_1\cdot E_2)^2}{2}\cdot\cos(\omega_1+\omega_2)t=\frac{(E_1\cdot E_2)^2}{4}\cdot[\cos(\omega_x-\omega_1-\omega_2)t+\cos(\omega_x+\omega_1+\omega_2)t] \quad (5)$$

$$\cos\omega_x t\cdot\frac{(E_1\cdot E_2)^2}{2}\cdot\cos(\omega_1-\omega_2)t=\frac{(E_1\cdot E_2)^2}{4}\cdot[\cos(\omega_x-\omega_1+\omega_2)t+\cos(\omega_x+\omega_1-\omega_2)t] \quad (6)$$

It will be appreciated by those skilled in the art upon review of equations 5 and 6, that the IM2 distortion components have been translated up in frequency by $\omega_x$. By carefully selecting $\omega_x$, one can place the IM2 distortion components outside the frequency band of interest where they can be attenuated by filtering. An added benefit of dynamic matching is that it also translates any DC component generated from a second order nonlinearity up in frequency by $\omega_x$ where it too can be filtered. This can be seen by substitution of Equations 2 and 3 into the second term of Equation 1 thereby yielding the following DC term:

$$a_2\cdot\frac{(E_1\cdot E_2)^2}{2} \quad (7)$$

To understand how IM2 distortion components are spread over frequency, consider a pseudo-random sequence function, $f_{pseudo}$**(t)**, which has the following spectrum in the frequency domain:

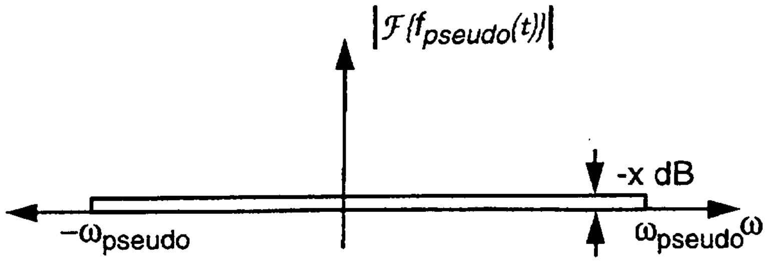


Now using the fact that multiplication in the time domain is convolution in the frequency domain, the composite response of

$$a_2\cdot(V_{lo}\cdot V_{rf})^2 \rightarrow f_{pseudo}(t)\cdot(V_{lo}\cdot V_{rf})^2 \leftrightarrow \mathcal{F}\{f_{pseudo}(t)\}\circledast\mathcal{F}\{(V_{lo}(t)\,V_{rf}(t))^2\}$$

is graphically shown below:

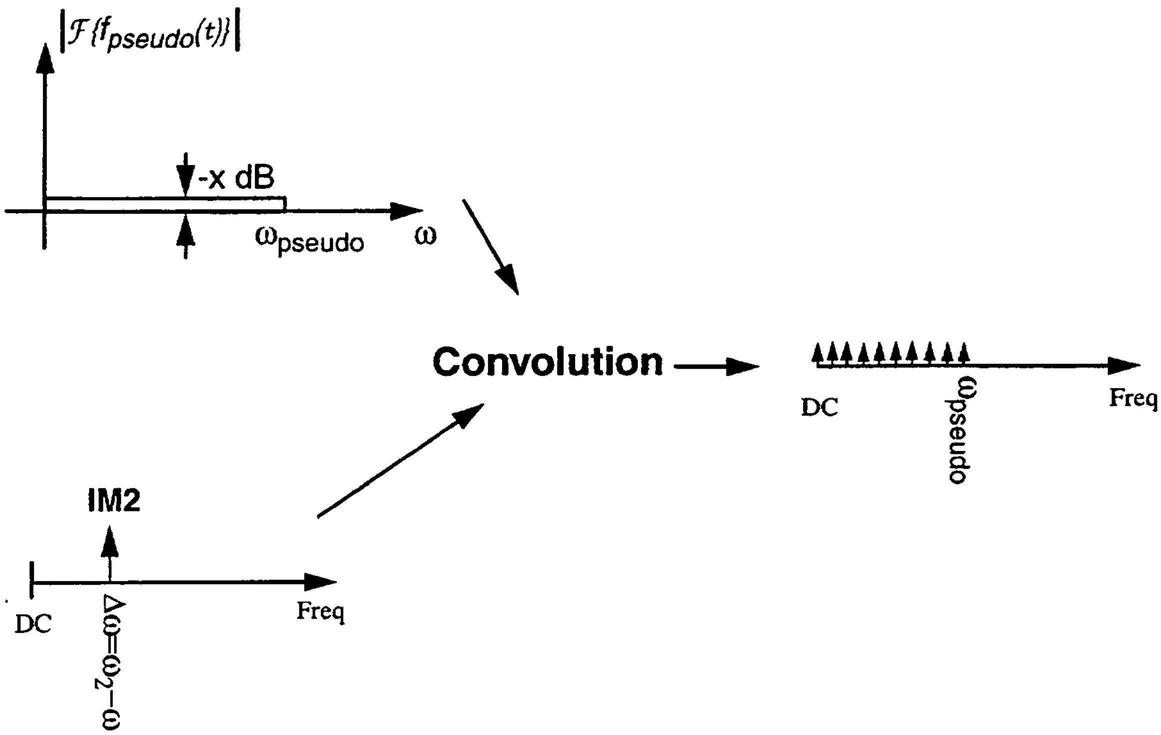


By choosing $f_{pseudo}$**(t)** to have insignificant magnitude, -x dB, in the frequency domain, the IM2 distortion component will be scaled by -x dB and spread over a wider frequency range than the desired frequency band.

As previously stated, the basic problem of second order intermodulation distortion within an integrated, fully differential mixer arises from mismatches or imbalances between like devices within the circuit (hereinafter referred to as a parametric mismatch). For the differential mixer 100 shown in FIG. 1, the main source of IM2 distortion originates from mismatches in the quadrature switching devices (Q1, Q2, Q3, Q4). Improved balance in the differential mixer 100 of FIG. 1 can be achieved by dynamically matching these devices.

FIG. 2 shows a differential RF mixer circuit 200 employing dynamic matching in accordance with the present invention. In accordance with this embodiment, a switching network comprising switches $S_1$-$S_8$ has been added to rotate the effective positions of transistor pairs Q1 and Q4 between positions A and D and the positions of transistor pairs Q2 and Q3 between positions B and C at a commutating frequency. The result of cyclically changing the position of each transistor pair is that the imbalance in the circuit elements may be modulated. By choosing the modulating frequency to be well beyond the corner frequency of the single pole filter formed by R1, C1, C3, C2, and R2, the IM2 distortion component may be eliminated by translating the IM2 distortion components to a frequency different from the desired frequency and attenuating the IM2 distortion via the single pole filter. The IM2 performance of the mixer 200 of FIG. 2 is illustrated in FIG. 3. Of note, the IM2 distortion 302 as exhibited by the mixer 200 is 24 decibels (dB) below that exhibited by the mixer 100 of FIG. 1.

During operation, the mixer circuit 200 receives an RF signal as an input for application to the emitters of transistors $Q_1$-$Q_4$. Likewise, the mixer receives a local oscillator (LO) reference signal as an input for application to the bases of transistors $Q_1$-$Q_4$. As is known, the application of these signals to devices $Q_1$-$Q_4$ will cause them to be mixed and provide an output which is the product of the RF signal and the local oscillator signal.

In accordance with the present embodiment, switches $S_1S_8$ are located at the input and the output of transistor $Q_1$-$Q_4$, respectively. Under the operation of a control or mitigation signal ($\phi,\bar{\phi}$), switches $S_1$-$S_8$ are operated at a frequency $f_{comm}$ different than the frequency of the desired output in order to modulate the imbalance exhibited by transistors $Q_1$-$Q_4$. As previously stated, the mitigation signal frequency can be selected so as to promote the attenuation of the undesired IM2 distortion components. This is accomplished by frequency translating the desired signal components twice. Once, by switches $S_5$-$S_8$, to translate the desired signal to a frequency different than the desired frequency and again by switches $S_1$-$S_4$ to recover the desired signal. The undesired signal components are translated once by the switches $S_1$-$S_4$ at the output of devices $Q_1$-$Q_4$ to translate the undesired signal components to a frequency different from the desired frequency prior to filtering.

Of note, the mitigation signal ($\phi,\bar{\phi}$) anticipated by the present embodiment is a square wave. Notwithstanding, it will be appreciated by those skilled in the art that the mitigation signal may comprise any periodic wave form such as,

for example, sinusoidal waves or saw tooth waves. In the alternative, frequency translation may be achieved by switching the polarity of the inputs and outputs of the elements exhibiting imbalance, for example, transistors $Q_1$-$Q_4$ at the frequency of $\omega_{comm}$.

One concern regarding this approach is the introduction of undesirable spurs. Specifically, the spurs of concern are those originating from the mixing of the mitigation signal at frequency $f_{comm}$ and any signal in the frequency range of local oscillatory frequency ⇧$\Delta f + f_{comm}$ ($\Delta f$ <= IF bandwidth) which are then down converted to baseband by mixing with the LO. Notwithstanding this concern, experimentation and empirical data show that such spurs can be controlled by the choice of $f_{comm}$.

A second concern regarding this approach is the overall device noise figure. Since several switching devices $S_1$-$S_8$ have been added to the mixer 200, the noise figure of the new mixer might potentially be higher. Fortunately, devices $S_1$-$S_8$ act as ON-OFF switches with a very low ON resistance of 10 to 20 Ohms. Their noise figure contribution of these devices is not significant.

As will be appreciated, there are a number of ways in which this switching technique can be applied to the conventional Gilbert Cell mixer topology of FIG. 2. One such alternative is shown in FIG. 4.

FIG. 4, like FIG. 2, depicts a Gilbert Cell mixer circuit employing dynamic matching to overcome the effects of parametric mismatch between devices $Q_1$, $Q_2$, $Q_3$, $Q_4$. As will be appreciated upon closer inspection, the primary different between FIG. 4 and FIG. 2 is the location and number of commutating switches required to perform dynamic matching.

With reference to FIG. 4, the commutating switches $S_1$-$S_4$ are located at the inputs and the outputs, respectively, of the mixer circuit 400 as opposed to the inputs and outputs of the devices $Q_1$-$Q_4$ as shown in FIG. 2. This modification reduces the required number of commutating switches and yet exhibits similar performance as the mixer 200 shown in FIG. 2.

It will be appreciated by those skilled in the art that the switching network of the present invention may be diodes, field-effect transistors (FET), transmission gates, bipolar junction transistors (BJT) or any other switching devices and/or technology. FIG. 4 is presented to articulate the point that there are numerous ways to deploy commutating switches within the topology of a mixer circuit to improve the IM2 distortion caused by device imbalance; such devices or elements to include transistors, resistors, diodes, inductors, capacitors, transformers, active baluns, and the like.

In addition to frequency translation, spreading is an alternative method of achieving dynamic matching. With reference to FIG. 5, a differential RF mixer circuit 500 employing spreading techniques to achieve dynamic matching of elements exhibiting parametric mismatch is shown. FIG. 6 is a timing diagram showing the operation thereof.
The circuit 500 works as follows. With reference to FIG. 6, during period 1, the collector of $Q_1$ is connected to Vop, the emitter of $Q_1$ is connected to node A, and the base of $Q_1$ is connected to $LO_p$. During period 2, the collector of Q1 is connected to Vom, the emitter is connected to node A, and the base is connected to $LO_M$. At this point, Q1 has effectively been switched into the position of Q2 as shown in period 1. During period 3, the collector of Q1 is connected to Vop, the emitter is connected to node B, and the base is connected to $LO_M$. Here, Q1 has been switched into the location of Q3 as shown in period 1. Finally, during period 4, the collector of Q1 is connected to Vom, the emitter is connected to node B, and the base is connected to $LO_p$. Q1 has now effectively been switched into the position of Q4 as shown in period 1. This is the end of the cycle and during period 5, transistor Q1 will return to its original position. By manipulating the switching network ($S_1$-$S_{12}$) connections, to and from transistors Q1, Q2, Q3, and Q4 can be altered to effectively rotate transistors $Q_1$-$Q_4$ through different physical positions within the mixer circuit 500 and, hence, randomize or spread the second order distortion term. Simulations performed with this topology show a greater than 20 dB improvement as compared to the conventional mixer topology 100 of FIG. 1.

While the preferred embodiments of the invention have been illustrated and described, it will be clear that the invention is not so limited. Numerous modifications, changes, variations, substitutions and equivalents will occur to those skilled in the art without departing from the scope of the present invention as defined by the appended claims. For example, dynamic matching as described herein can be applied to any RF component exhibiting parametric mismatch; such components to include resistors, capacitors, inductors, diodes, transistors, transformers, active baluns, such as single-ended to differential converter, and the like. These techniques can likewise be applied to any mixer topology and may be further employed within a wireless or wireline communication system.

With reference to FIGs. 7-11, the application of switching networks to provide dynamic matching within other mixer topologies is specifically shown. For example, FIG. 7 depicts an active harmonic mixer 700 employing dynamic matching in accordance with the present invention. During operation, when the mitigation signal amplitude is high, ($\phi$), Q1's collector is tied to Vop and its emitter is tied to node A, Q2's collector is tied to Vom and its emitter is tied to node A, Q3's collector is tied to Vop and its emitter is tied to node B, and Q4's collector is tied to Vom and its emitter is tied to node B. During this period, the IM2 distortion component has a defined amplitude, $A_1$, that is unique to the above-defined set of switching network connections. When the mitigation signal goes low, ($\overline{\phi}$), Q1's collector is tied to Vom and its emitter is tied to node B, Q2's collector is tied to Vop and its emitter is tied to node B, Q3's collector is tied to Vom and its emitter is tied to node A, and Q4's collector is tied to Vom and its emitter is tied to node A. During this period,

the IM2 distortion component has a second defined amplitude, $A_2$ that is unique to the set of switching network connections associated with the mitigation signal being in the low state. If the mitigation signal toggles at a frequency $f_{sw}$, then the IM2 distortion component amplitude will change from A1 to A2 and back to A1 at the same frequency. By choosing $f_{sw}$ appropriately, the IM2 distortion component can be easily filter by filter stage at the output of the mixer 700.

Following this same technique, FIG. 8 depicts a single-balanced RF mixer 800 employing dynamic matching in accordance with the present invention.

FIG. 9 is a first embodiment of a CMOS down conversion mixer 900 employing dynamic matching in accordance with the present invention. FIG. 10 is a second embodiment of a CMOS down conversion mixer 1000 employing dynamic matching. FIG. 11 is a timing diagram for use in association with the devices 900 and 1000 of FIGs. 9 and 10. The primary difference between FIGs. 9 and 10 is the application of the input signal to the gates of devices M1-M4 as shown in FIG. 9 as opposed to application of the input signal to the drains of devices M1-M4 as shown in FIG. 10. As will be appreciated by those skilled in the art, the devices M1-M4 operate in saturation in FIG. 10 while they operate in the linear region in FIG. 9.

As noted above, in order to obtain additional reduction in spurious response, a spreading clock (noted above as $f_{pseudo}(t)$) can be generated using pseudo-random data. The effect is to spread the spectrum of the DC due to a spurious response into a spread spectrum signal which has most of its power outside of the receive filter bandwidth.

FIG. 12 generally depicts a block diagram of a circuit used to generate a spreading clock in accordance with the invention. As shown in FIG. 12, a receive voltage controlled oscillator (RX VCO) 1200 generates a signal at a frequency equal or near the RX wanted channel frequency which is divided by dividing block 1203 to generate the clock signal CLK(t) 1205. In the preferred embodiment, the clock signal CLK(t) 1205 is between 100-200 MHz. The frequency fclk of the clock signal is chosen to be higher in frequency than the overall RX band (for example > 35Mhz for GSM) such that any blocking signal at fclk offset from the wanted channel which could mix with the clock signal CLK(t) (CLK spur) would be attenuated substantially by an RF preselector filter. The clock signal CLK(t) 1205 is also input to another dividing block 1206 which further divides the clock signal CLT(t) 1205 to produce a signal 1209 at the chip frequency fc (t). In the preferred embodiment, the chip frequency $f_c(t)$ is between 3-6 MHz.

The signal 1209 at the chip frequency $f_c(t)$ is input into a pseudo random (PN) generator 1212 which outputs the spread spectrum signal SS(t) 1215. The spread spectrum signal SS(t) 1215 is a pseudorandom data signal output by PN generator 1212 of n bits which takes values of +1 and -1. The PN generator 1212 will thus have a periodicity of $2^n$=N (e.g., for n=7 bits, N=128). As one skilled in the art will appreciate, the value of N chosen for the PN generator 1212 and the frequency of signals CLK(t) 1205 and SS(t) 1215 are completely variable and are dependent upon the requirements of the receiver design. Continuing, signals CLK(t) 1205 and SS(t) 1215 are then mixed in XOR gate 1218 to produce a modulated clock signal CLKSS(t) which is amplitude modulated by SS(t). The theoretical gain processing (1 Hz bandwidth) is in the range of $10\log_{10}(1/N)$ = 21 dB for N=128 (or a 7 bit PN generator). The modulated clock signal CLKSS(t) is thus used to spread an undesired signal across a range of frequencies by its application at the inputs and outputs of the plurality of elements exhibiting parametric mismatch as described above.

The spectrum of signal CLKSS(t) is such that its spreading is relatively limited to a bandwidth around fclk such that if it mixes with blocking signals which are outside of the RF preselector frequency (fclk offset from the wanted RF channel) it is already attenuated by the RF preselector filter. Note that the RF preselector filter does provide limited out-of-band attenuation mainly at high RF frequencies, which requires this additional spreading gain. This is shown in FIG. 13.

Also, complex spreading could be chosen for additional spreading gain. This is implemented by having a spreading clock CLKSSI for the Inphase (I) Mixer and a spreading clock CLKSSQ for the Quadrature Mixer such that the clocks are different. The complex spreading is equivalent to spreading a vector rather than a real component. The vector spur will then be expressed as

$$Vleak(t) = Ileak(t) + j.\ Qleak(t) = Ablocker/8*(CLKSSI(t)+j.CLKSSQ(t)).$$

While the invention has been particularly shown and described with reference to a particular embodiment, it will be understood by those skilled in the art that various changes in form and details may be made therein without departing from the scope of the invention as defined in the appended Claims. The corresponding structures, materials, acts and equivalents of all means or step plus function elements in the claims below are intended to include any structure, material, or acts for performing the functions in combination with other claimed elements as specifically claimed.

## Claims

1. A method for improving the second order intermodulation distortion of a radio frequency integrated fully differential mixer circuit (200, 400, 500, 700, 800, 1000), having commutating input and output stages, comprising the steps of:

    applying a mitigating signal to a switching network comprising switches ($S_1$-$S_8$) to rotate effective positions of the commutating stages;
    applying a signal to be mixed ($RF_P$, $RF_M$) and a local oscillator signal ($LO_P$, $LO_M$) to said stages exhibiting parametric mismatch to generate output signals comprising desired signal components and undesired second order intermodulation distortion components;
    spreading the undesired signal across a range of frequencies by application of a spreading signal at the commutating input and output stages exhibiting parametric mismatch, wherein the spreading signal is a pseudo-random code which is generated by amplitude modulating a clock signal such that undesired components are translated by the switching network to a frequency different to the desired signal components.

2. The method of claim 1, wherein a receive preselector filter is positioned before a mixing stage.

3. The method of claim 1 or 2, wherein the commutating stages exhibiting parametric mismatch are selected from the group consisting of capacitors, inductors, transformers, transistors, resistors, and diodes.

4. The method of 1, 2 or 3, wherein the spreading signal related to a mixer in an In-phase branch and a spreading signal related to a mixer in a Quadrature-phase branch are different and provide complex spreading.

5. An integrated fully differential radio frequency mixer circuit (200, 400, 500, 700, 800, 1000) having commutating input and output stages ($Q_1$, $Q_2$; $Q_3$, $Q_4$; $M_1$, $M_2$) exhibiting parametric mismatch, that generate desired signal components and undesired second order intermodulation distortion components in response to a signal to be mixed ($RF_P$, $RF_M$) and a local oscillator signal ($LO_P$, $LO_M$) being applied:
   wherein the radio frequency mixer circuit includes a switching network comprising switches ($S_1$-$S_8$) arranged to rotate effective positions of the commutating stages in response to a mitigating signal ($\phi$, $\bar{\phi}$; $\phi_1$, $\bar{\phi}_1$, $\phi_2$, $\bar{\phi}_2$, $\phi_3$, $\bar{\phi}_3$, $\phi_4$, $\bar{\phi}_4$)
   wherein a pseudo-random code spreading signal is applied to the commutating input and output stages to spread the undesired second order intermodulation distortion components generated by the commutating stages; and
   the pseudo-random code is generated by amplitude modulating a clock signal (1205) such that the undesired components are translated by the switching network to a frequency different from the desired signal components.

6. The mixer of claim 5, wherein the plurality of elements exhibiting parametric mismatch are selected from the group consisting of transistors, resistors, inductors, diodes, and transformers.

7. The mixer of claim 5, wherein a switching network switch is a device selected from the group consisting of diodes, field effect transistors, transmission gates, and bipolar junction transistors.

8. The mixer of claim 5, 6 or 7, wherein the spreading signal input into a mixer in an In-phase branch and a spreading signal input into a mixer in a Quadrature-phase branch are different and provide complex spreading.

9. A wireless or wireline communication device having an integrated fully differential mixer circuit according to claim 5.

## Patentansprüche

1. Verfahren zur Verbesserung der Intermodulationsverzerrung zweiter Ordnung einer integrierten Radiofrequenz-Volldifferentialmischerschaltung (200, 400, 500, 700, 800, 1000), das über kommutierende Eingabe- und Ausgabestufen verfügt, wobei das Verfahren die folgenden Schritte umfasst:

    Zuführen eines abschwächenden Signals zu einem Schaltnetz, das Schalter ($S_1$-$S_8$) umfasst, um wirksame Stellungen der kommutierenden Stufen zu drehen;
    Zuführen eines zu mischenden Signals ($RF_P$, $RF_M$) und ein Lokaloszillatorsignal ($LO_P$, $LO_M$) zu den Stufen, die eine parametrische Fehlanpassung zeigen, um Ausgangssignale zu erzeugen, die erwünschte Signalkomponenten und unerwünschte Intermodulationsverzerrungskomponenten zweiter Ordnung umfassen;
    Spreizen des unerwünschten Signals über einen Bereich von Frequenzen durch Zuführung eines Spreizsignals

bei den kommutierenden Eingabe- und Ausgabestufen, die eine parametrische Fehlanpassung zeigen, wobei das Spreizsignal ein Pseudozufallscode ist, der durch eine Amplitudenmodulation eines Taktsignals erzeugt wird, so dass unerwünschte Komponenten durch das Schaltnetz in eine Frequenz umgewandelt werden, die von den erwünschten Signalkomponenten verschieden ist.

**2.** Verfahren gemäß Anspruch 1, wobei ein Empfangsvorwahlfilter vor einer Mischstufe angeordnet wird.

**3.** Verfahren gemäß Anspruch 1 oder 2, wobei die kommutierenden Stufen, die eine parametrische Fehlanpassung zeigen, aus der Gruppe ausgewählt werden, die Kondensatoren, Induktoren, Transformatoren, Transistoren, Widerstände und Dioden umfasst.

**4.** Verfahren gemäß Anspruch 1, 2 oder 3, wobei das Spreizsignal, das sich auf einen Mischer in einem In-Phase-Zweig bezieht und ein Spreizsignal, das sich auf einen Mischer in einem Quadratur-Phase-Zweig bezieht, unterschiedlich sind und ein komplexes Spreizen zur Verfügung stellen.

**5.** Integrierte Volldifferentialradiofrequenzmischerschaltung (200, 400, 500, 700, 800, 1000), die über kommutierende Eingabe- und Ausgabestufen ($Q_1$, $Q_2$; $Q_3$, $Q_4$; $M_1$, $M_2$) verfügt, die eine parametrische Fehlanpassung zeigen, die erwünschte Signalkomponenten und unerwünschte Intermodulationsverzerrungskomponenten zweiter Ordnung erzeugen, in Reaktion auf ein zu mischendes Signal ($RF_P$, $RF_M$) und ein Lokal-Oszillator-Signal ($LO_P$, $LO_M$), die zugeführt werden:
wobei die Radiofrequenz-Mischerschaltung ein Schaltnetz umfasst, das Schalter ($S_1$-$S_8$) umfasst, die angeordnet sind, um wirksame Stellungen der kommutierenden Stufen in Reaktion auf ein abschwächendes Signal ($\phi_1$, $\overline{\phi}_1$; $\phi_2$, $\overline{\phi}_2$; $\phi_3$, $\overline{\phi}_3$; $\phi_4$, $\overline{\phi}_4$) zu ändern;
wobei ein Pseudozufallscodespreizsignal zu den kommutierenden Eingabe- und Ausgabestufen zugeführt wird, um die unerwünschten Intermodulationsverzerrungskomponenten zweiter Ordnung, die durch die kommutierenden Stufen erzeugt werden, zu spreizen; und
wobei der Pseudozufallscode durch eine Amplitudenmodulation eines Taktsignals (1205) erzeugt wird, so dass die unerwünschten Komponenten durch das Schaltnetz in eine Frequenz umgewandelt werden, die von den erwünschten Signalkomponenten verschieden ist.

**6.** Mischer gemäß Anspruch 5, wobei die Mehrzahl von Elementen, die eine parametrische Fehlanpassung zeigen, aus der Gruppe ausgewählt wird, die Transistoren, Widerstände, Induktoren, Dioden und Transformatoren umfasst.

**7.** Mischer gemäß Anspruch 5, wobei ein Schaltnetzschalter eine Vorrichtung ist, die aus der Gruppe ausgewählt wird, die Dioden, Feldeffekttransistoren, Übertragungsgates und Bipolartransistoren umfasst.

**8.** Mischer gemäß der Ansprüche 5, 6 oder 7, wobei das in einen Mischer in einem In-Phase-Zweig eingegebene Spreizsignal und ein in einen Mischer in einem Quadratur-Phase-Zweig eingegebene Spreizsignal verschieden sind und eine komplexe Spreizung zur Verfügung stellen.

**9.** Drahtlos- oder Wireline-Kommunikationsvorrichtung, die über eine integrierte Volldifferentialmischerschaltung gemäß Anspruch 5 verfügt.

## Revendications

**1.** Procédé pour améliorer la distorsion d'intermodulation de second ordre d'un circuit de mélangeur différentiel pleinement intégré radiofréquence (200, 400, 500, 700, 800, 1000) comportant des étages d'entrée et de sortie de commutation, comprenant les étapes de :

application d'un signal d'allègement sur un réseau de commutation comprenant des commutateurs ($S_1$-$S_8$) pour faire tourner des positions effectives des étages de commutation ;
application d'un signal destiné à être mélangé ($RF_P$, $RF_M$) et d'un signal d'oscillateur local ($LO_P$, $LO_M$) sur lesdits étages présentant une désadaptation paramétrique afin de générer des signaux de sortie comprenant des composantes de signal souhaitées et des composantes de distorsion d'intermodulation de second ordre non souhaitées ;
étalement du signal non souhaité sur une plage de fréquences au moyen de l'application d'un signal d'étalement au niveau des étages d'entrée et de sortie de commutation présentant une désadaptation paramétrique, dans

lequel le signal d'étalement est un code pseudo-aléatoire qui est généré en modulant en amplitude un signal d'horloge de telle sorte que des composantes non souhaitées soient translatées par le réseau de commutation vers une fréquence différente des composantes de signal souhaitées.

**2.** Procédé selon la revendication 1, dans lequel un filtre de presélecteur de réception est positionné avant un étage de mélange.

**3.** Procédé selon la revendication 1 ou 2, dans lequel les étages de commutation présentant une désadaptation paramétrique sont sélectionnés parmi le groupe comprenant des condensateurs, des inducteurs, des transformateurs, des transistors, des résistances et des diodes.

**4.** Procédé selon la revendication 1, 2 ou 3, dans lequel le signal d'étalement rapporté à un mélangeur dans une branche en phase et un signal d'étalement rapporté à un mélangeur dans une branche en quadrature de phase sont différents et assurent un étalement complexe.

**5.** Circuit de mélangeur radiofréquence pleinement différentiel intégré (200, 400, 500, 700, 800, 1000) présentant des étages d'entrée et de sortie de commutation ($Q_1$, $Q_2$ ; $Q_3$, $Q_4$ ; $M_1$, $M_2$) présentant une désadaptation paramétrique, qui génèrent des composantes de signal souhaitées et des composantes de distorsion d'intermodulation de second ordre non souhaitées en réponse à un signal destiné à être mélangé ($RF_P$, $RF_M$) et à un signal d'oscillateur local ($LO_P$, $LO_M$) qui sont appliqués,
dans lequel le circuit de mélangeur radiofréquence inclut un réseau de commutation qui comprend des commutateurs ($S_1$-$S_8$) agencés pour faire tourner des positions effectives des étages de commutation en réponse à un signal d'allègement (($\phi$, $\overline{\phi}$; $\phi_1$, $\overline{\phi}_1$; $\phi_2$, $\overline{\phi}_2$; $\phi_3$, $\overline{\phi}_3$; $\phi_4$, $\overline{\phi}_4$),
dans lequel un signal d'étalement de code pseudo-aléatoire est appliqué sur les étages d'entrée et de sortie de commutation pour étaler les composantes de distorsion d'intermodulation de second ordre non souhaitées qui sont générées par les étages de commutation ; et
le code pseudo-aléatoire est généré en modulant en amplitude un signal d'horloge (1205) de telle sorte que les composantes non souhaitées soient translatées par le réseau de commutation selon une fréquence différente des composantes de signal souhaitées.

**6.** Mélangeur selon la revendication 5, dans lequel les éléments de la pluralité d'éléments présentant des désadaptations paramétriques sont choisis parmi le groupe comprenant des transistors, des résistances, des inducteurs, des diodes et des transformateurs.

**7.** Mélangeur selon la revendication 5, dans lequel un commutateur de réseau de commutation est un dispositif choisi parmi le groupe comprenant des diodes, des transistors à effet de champ, des portes de transmission et des transistors à jonction bipolaire.

**8.** Mélangeur selon la revendication 5, 6 ou 7, dans lequel le signal d'étalement qui est entré dans un mélangeur dans une branche en phase et un signal d'étalement qui est entré dans un mélangeur dans une branche en quadrature de phase sont différents et assurent un étalement complexe.

**9.** Dispositif de communication sans fil ou par ligne filaire comportant un circuit de mélangeur pleinement différentiel intégré selon la revendication 5.

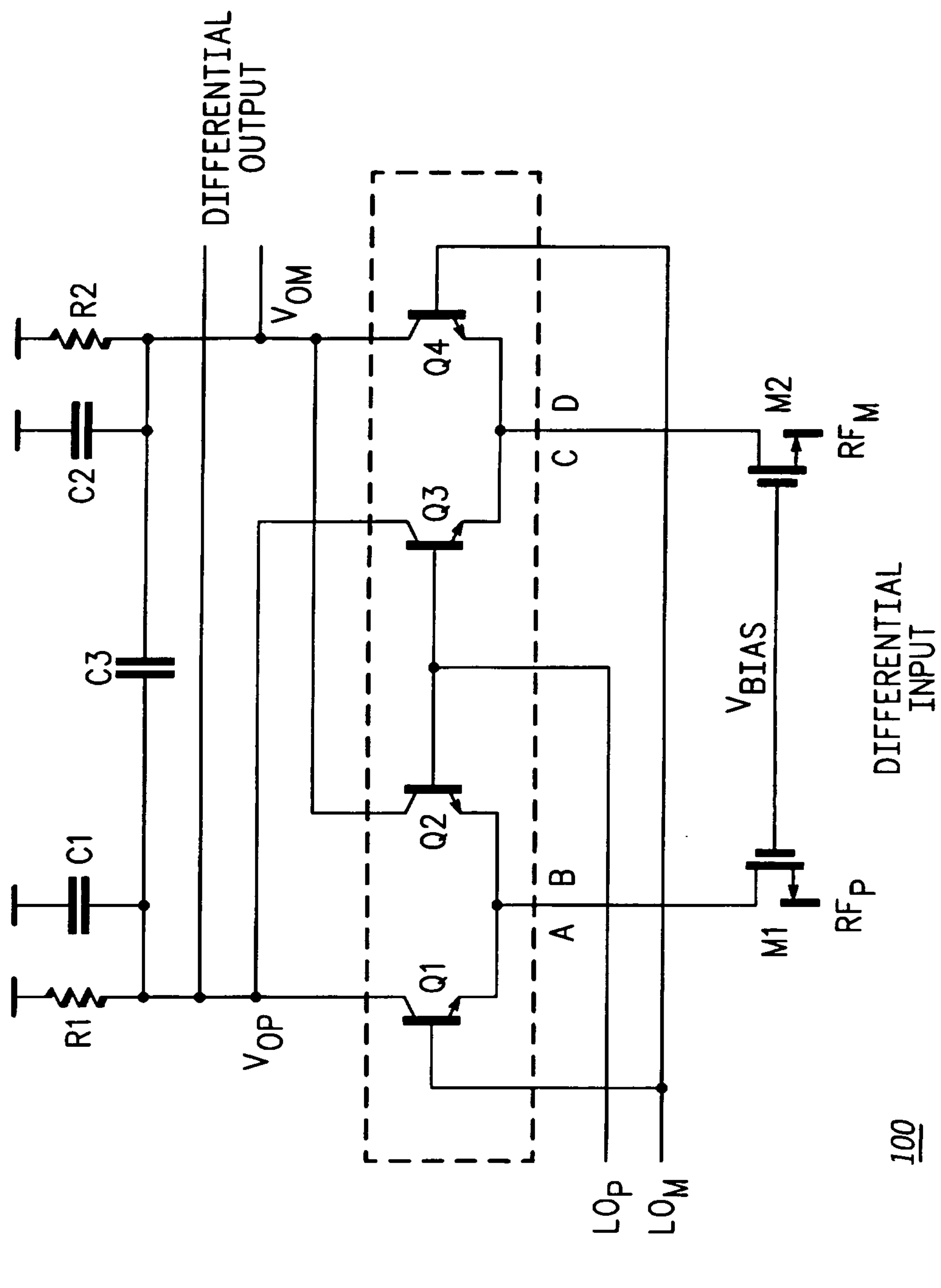


*FIG.1*
-PRIOR ART-

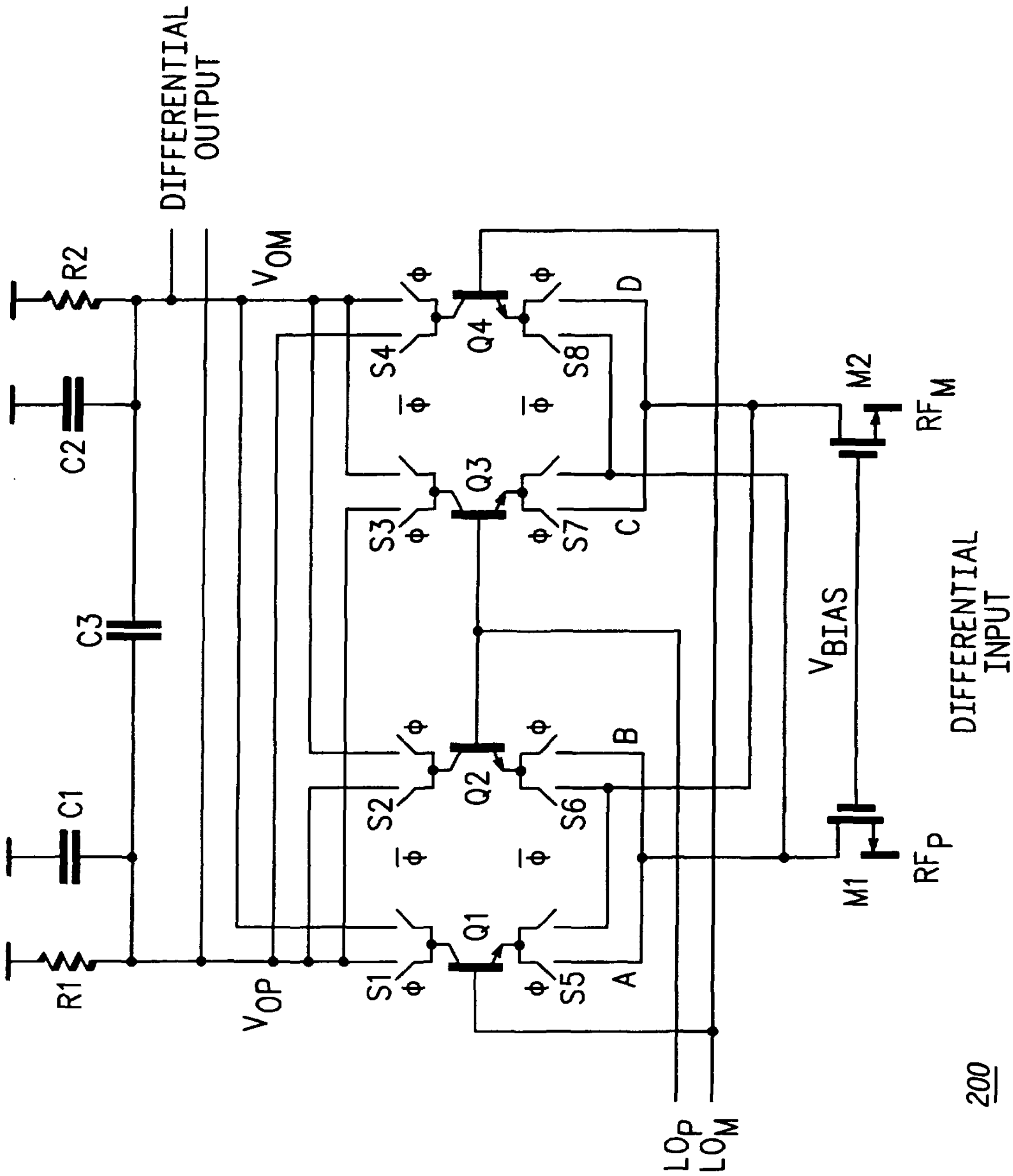
R1
R2
C1
C2
C3
DIFFERENTIAL OUTPUT
$V_{OP}$
$V_{OM}$
S1
S2
S3
S4
S5
S6
S7
S8
Q1
Q2
Q3
Q4
A
B
C
D
M1
M2
$RF_P$
$RF_M$
$V_{BIAS}$
DIFFERENTIAL INPUT
$LO_P$
$LO_M$

200

FIG.2

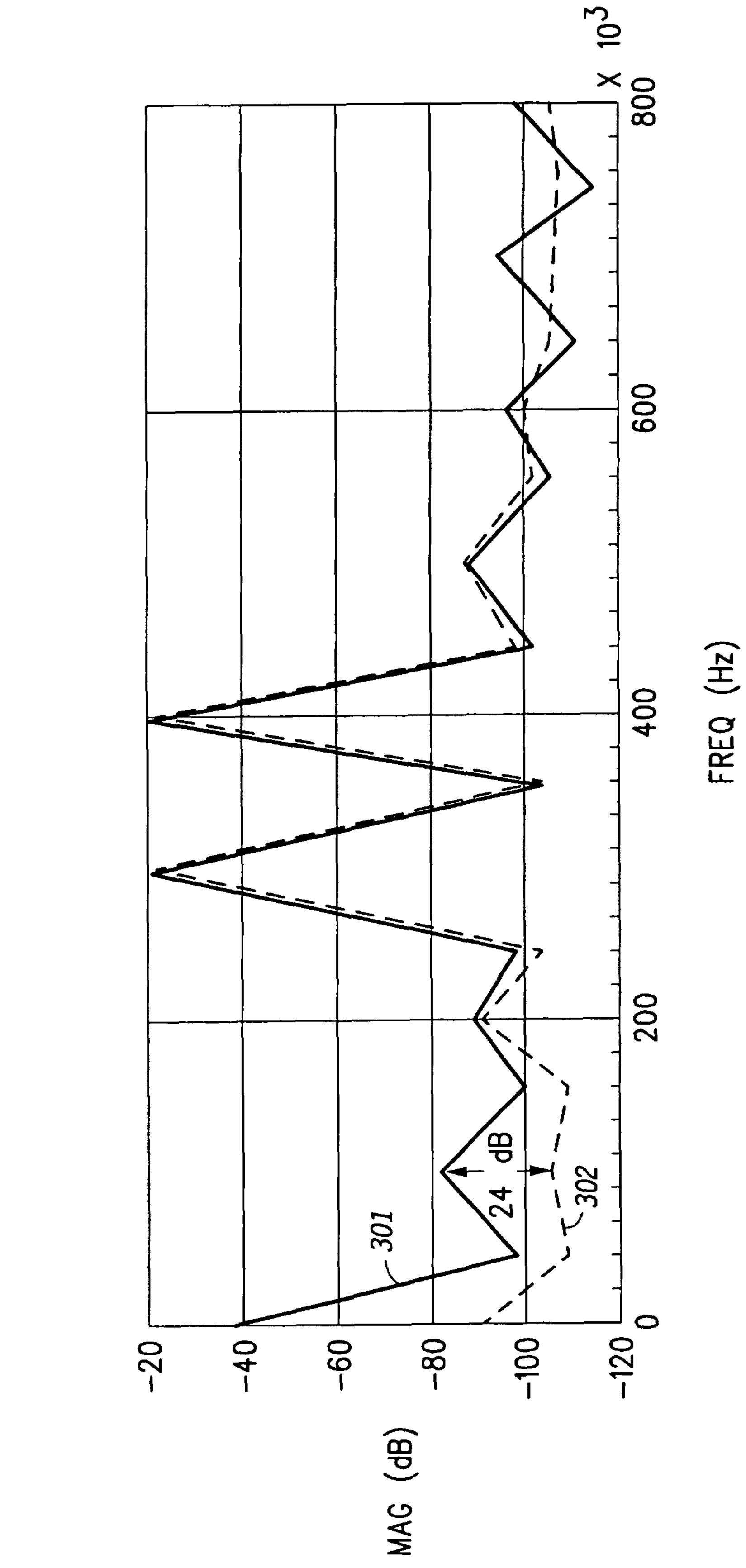
MAG (dB)
-20
-40
-60
-80
-100
-120
0
200
400
600
800
X 10^3
FREQ (Hz)
301
302
24 dB

FIG.3

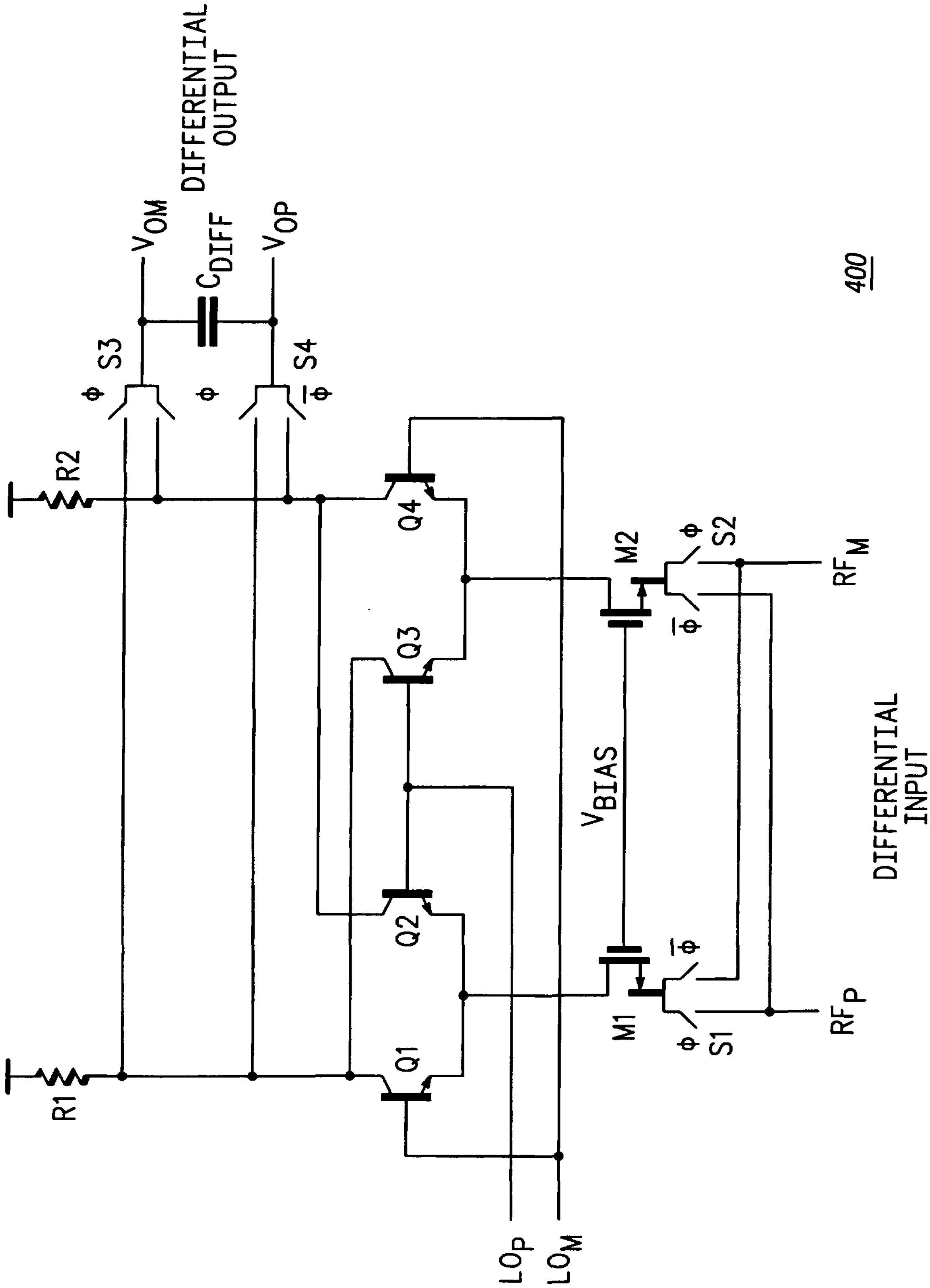
DIFFERENTIAL OUTPUT
$V_{OM}$
$C_{DIFF}$
$V_{OP}$
S3
S4
R1
R2
Q1
Q2
Q3
Q4
M1
M2
S1
S2
$V_{BIAS}$
$LO_P$
$LO_M$
$RF_P$
$RF_M$
DIFFERENTIAL INPUT
400

FIG. 4

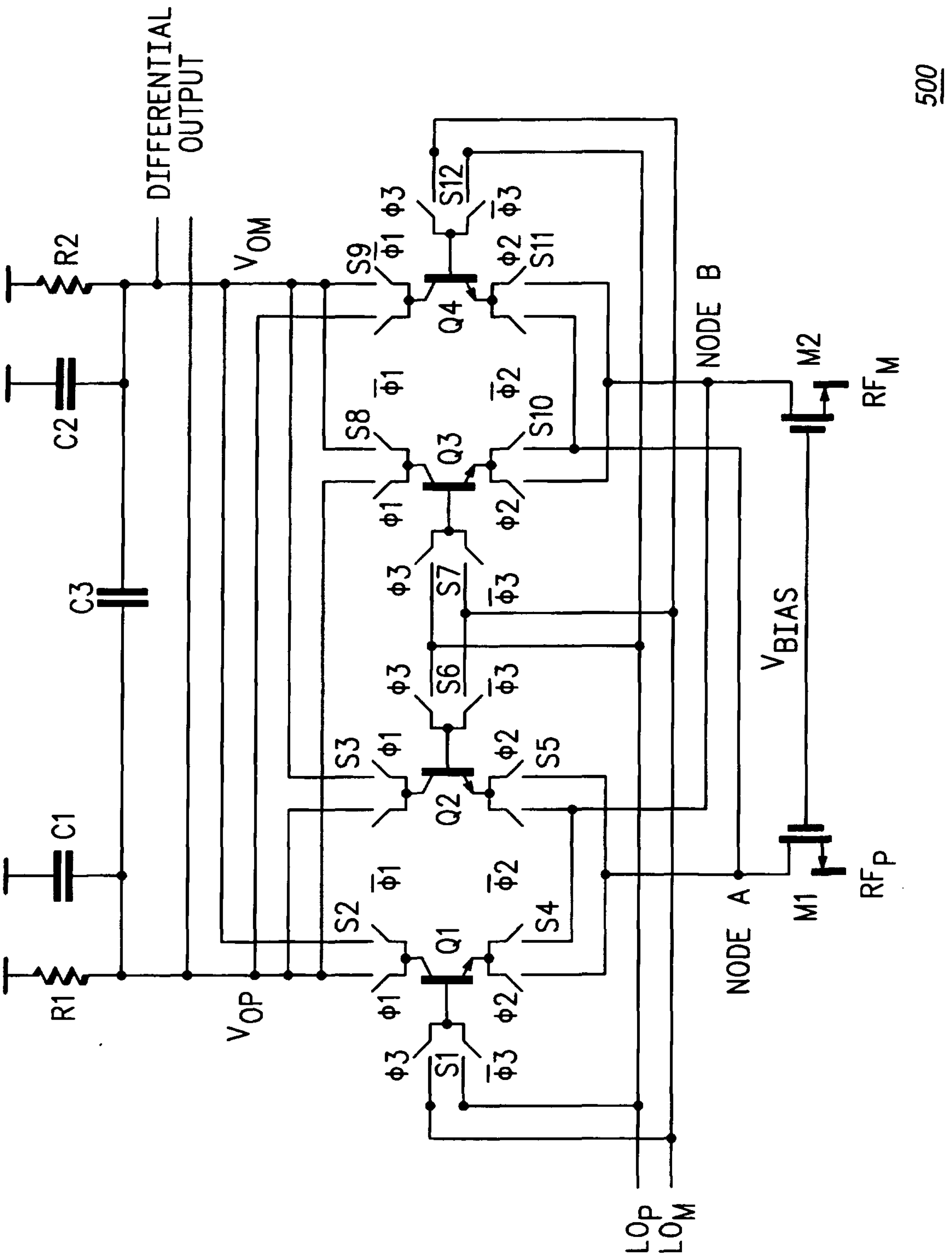

DIFFERENTIAL OUTPUT
R1
R2
C1
C2
C3
$V_{OP}$
$V_{OM}$
Q1
Q2
Q3
Q4
S1
S2
S3
S4
S5
S6
S7
S8
S9
S10
S11
S12
$\phi 1$
$\overline{\phi 1}$
$\phi 2$
$\overline{\phi 2}$
$\phi 3$
$\overline{\phi 3}$
NODE A
NODE B
$V_{BIAS}$
M1
M2
$RF_P$
$RF_M$
$LO_P$
$LO_M$
500


*FIG.5*

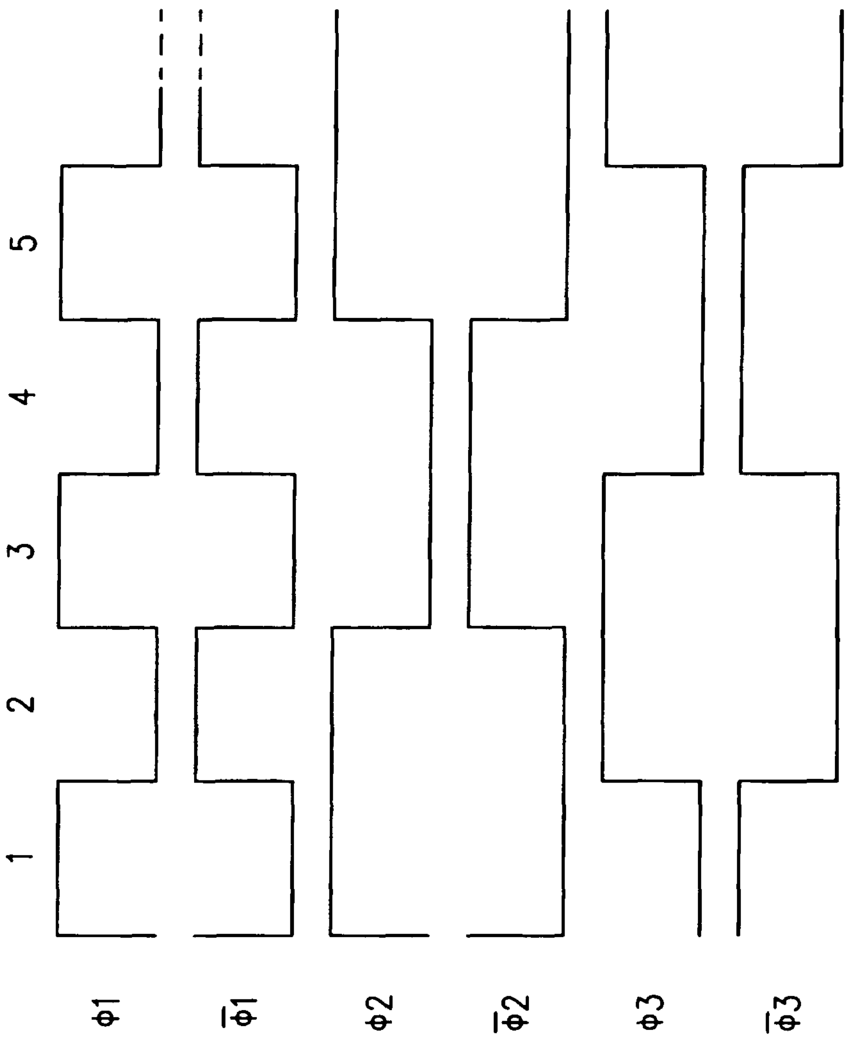


*FIG.6*

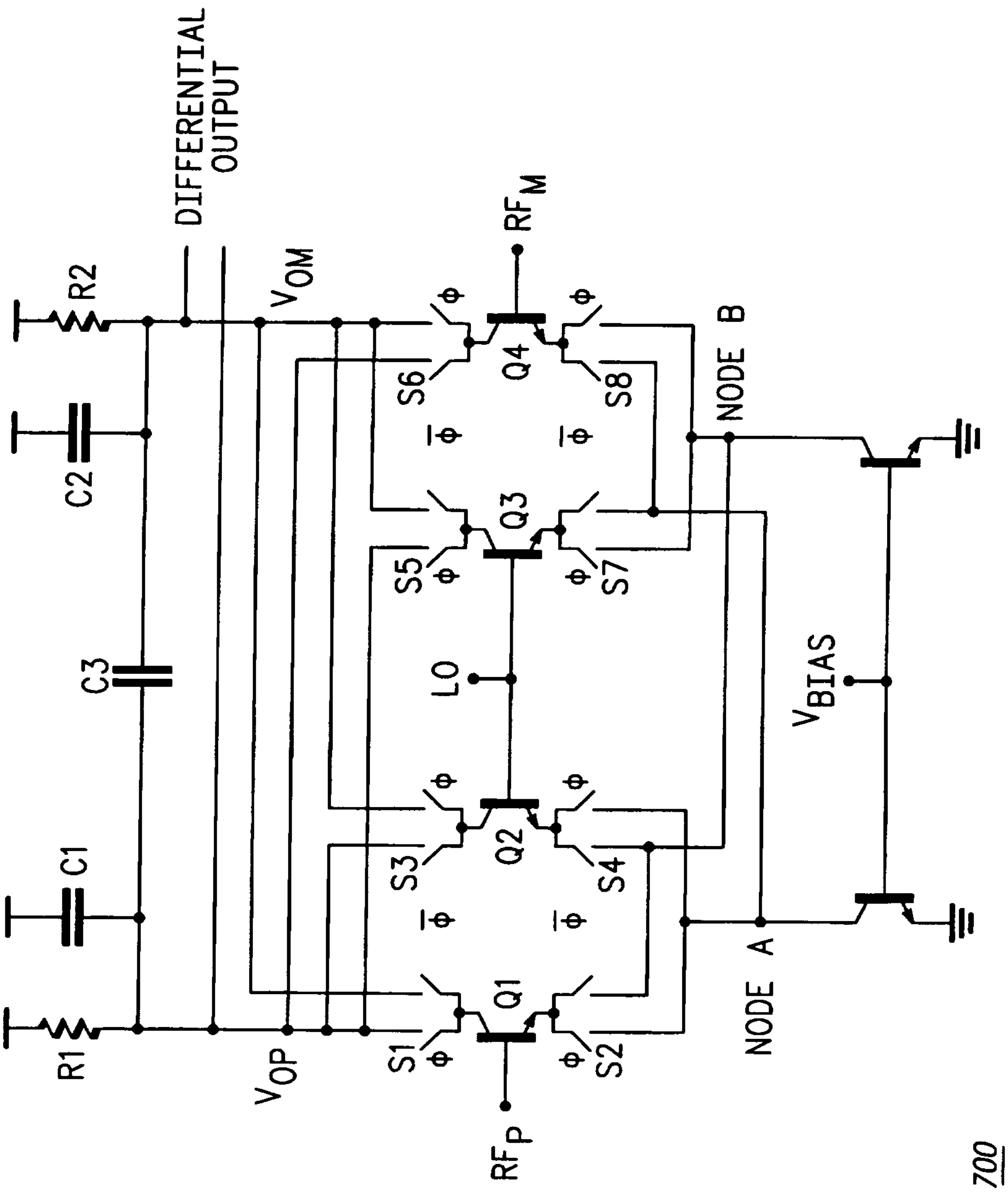
DIFFERENTIAL OUTPUT
R1
R2
C1
C2
C3
$V_{OP}$
$V_{OM}$
$RF_P$
$RF_M$
S1
S2
S3
S4
S5
S6
S7
S8
Q1
Q2
Q3
Q4
LO
NODE A
NODE B
$V_{BIAS}$


700

FIG. 7

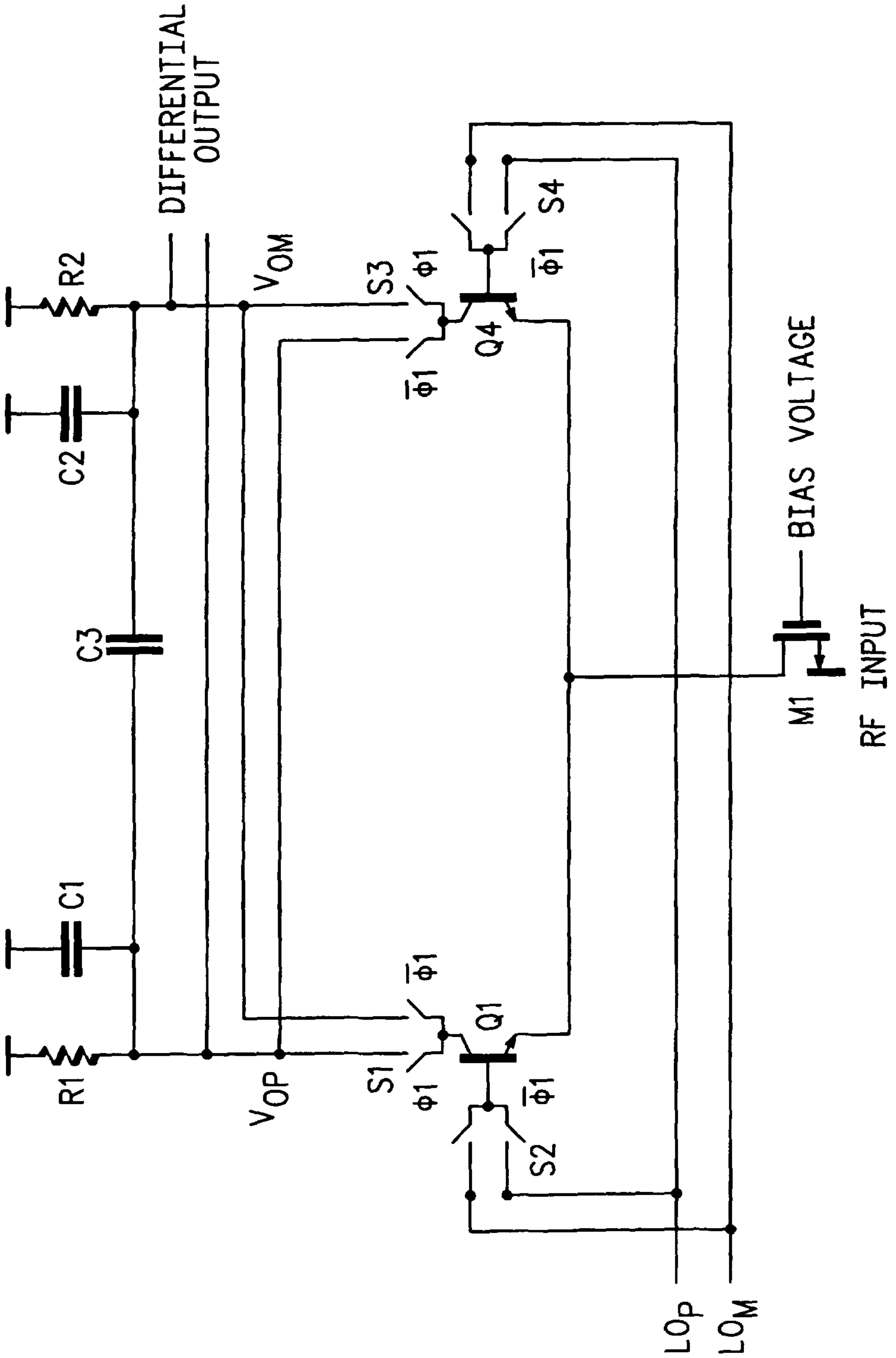
DIFFERENTIAL OUTPUT
R1
R2
C1
C2
C3
$V_{OP}$
$V_{OM}$
S1
S2
S3
S4
Φ1
$\overline{Φ1}$
Q1
Q4
M1
BIAS VOLTAGE
RF INPUT
$LO_P$
$LO_M$

800

FIG.8

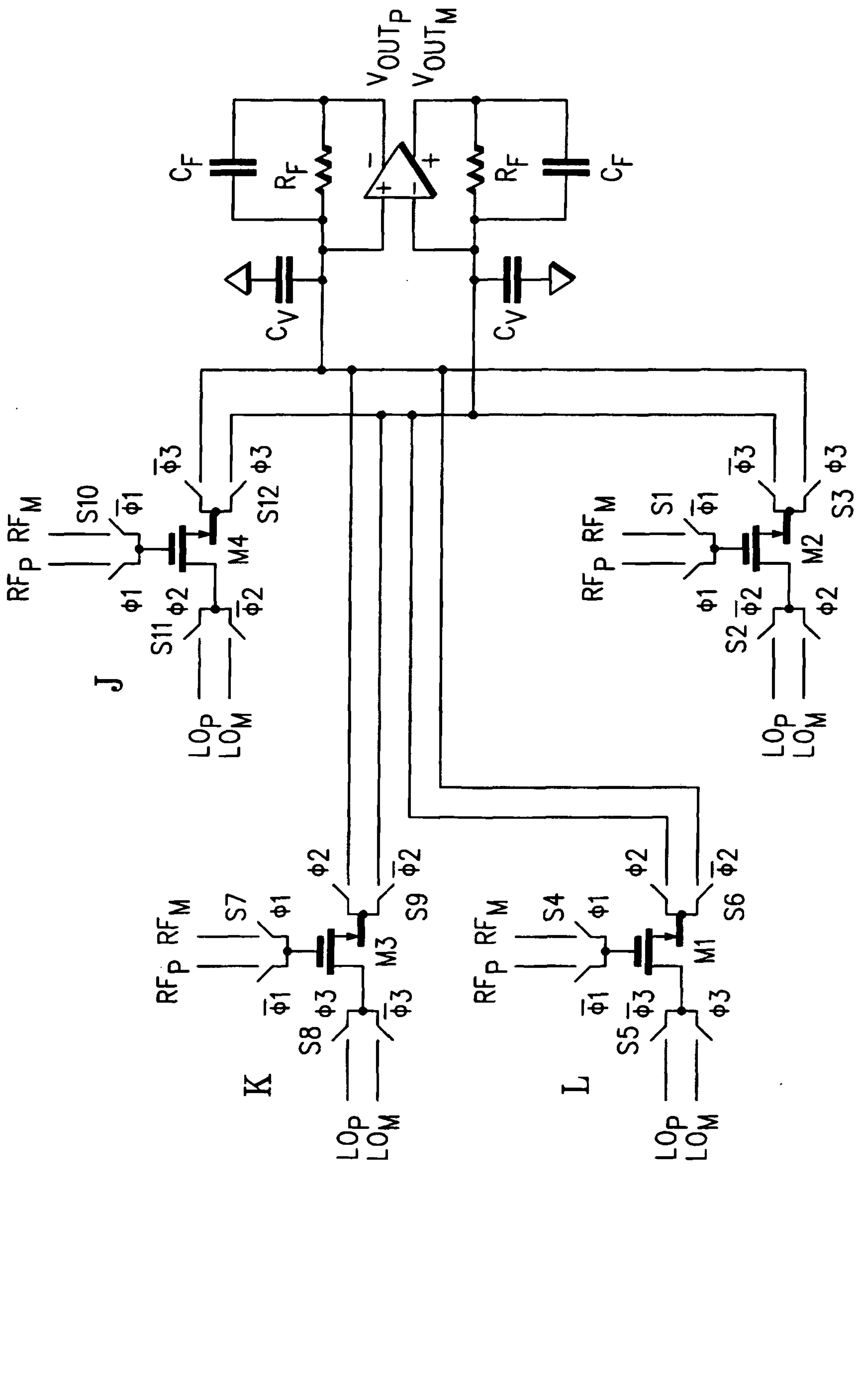

$V_{OUT_P}$
$V_{OUT_M}$
$C_F$
$R_F$
$C_V$
J
K
L
M
$RF_P$
$RF_M$
$LO_P$
$LO_M$
M1
M2
M3
M4
S1
S2
S3
S4
S5
S6
S7
S8
S9
S10
S11
S12


FIG.9

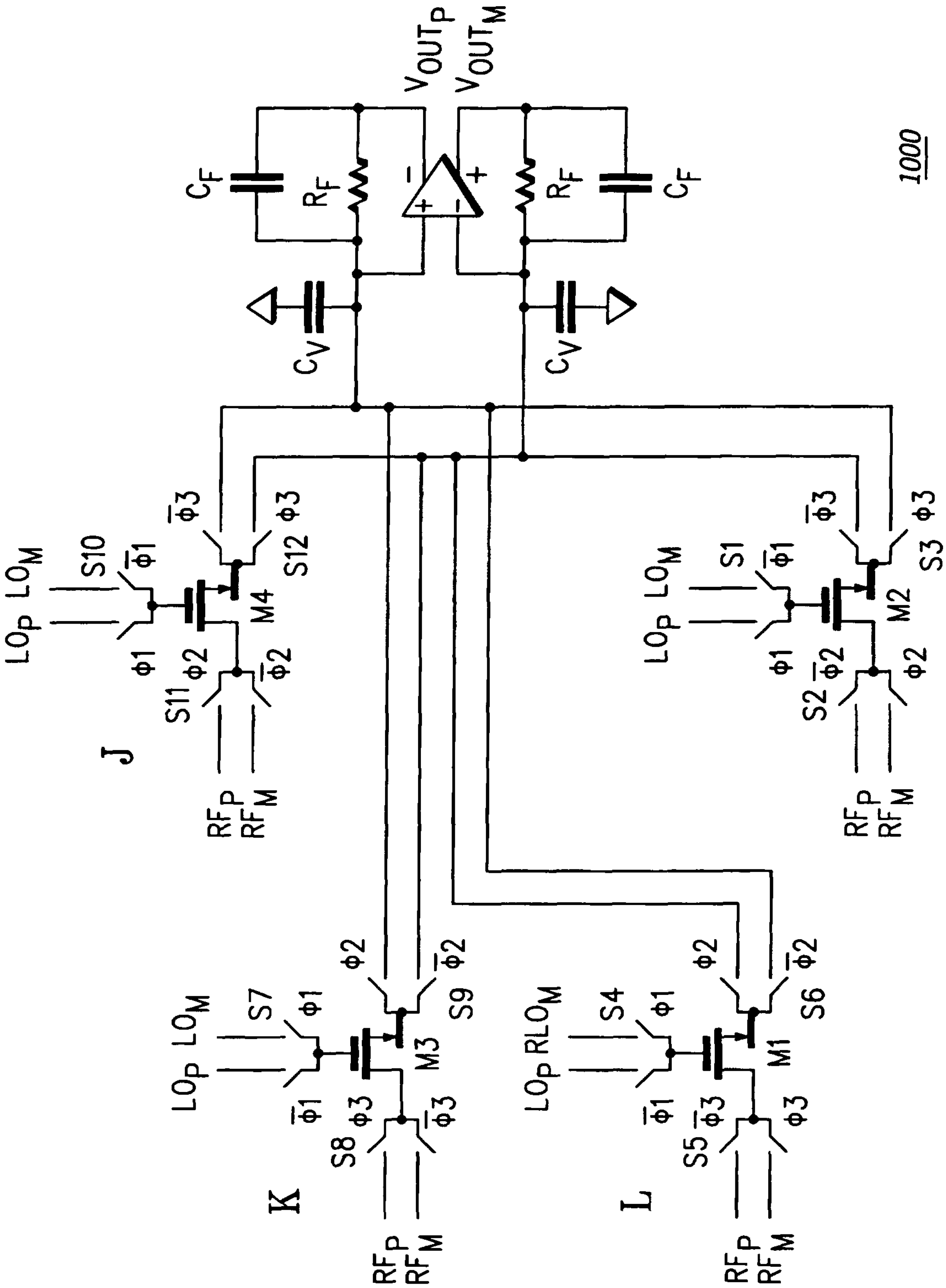

$V_{OUTP}$
$V_{OUTM}$
$C_F$
$R_F$
$C_V$
$LO_P$ $LO_M$
$LO_P$ $RLO_M$
$RF_P$
$RF_M$
J
K
L
M
M1
M2
M3
M4
S1
S2
S3
S4
S5
S6
S7
S8
S9
S10
S11
S12
φ1
$\overline{φ1}$
φ2
$\overline{φ2}$
φ3
$\overline{φ3}$
1000


FIG.10

| DEVICE | PERIOD 1 | PERIOD 2 | PERIOD 3 | PERIOD 4 |
|---|---|---|---|---|
| M1 | L | M | K | J |
| M2 | M | K | J | L |
| M3 | K | J | L | M |
| M4 | J | L | M | K |

FIG.11

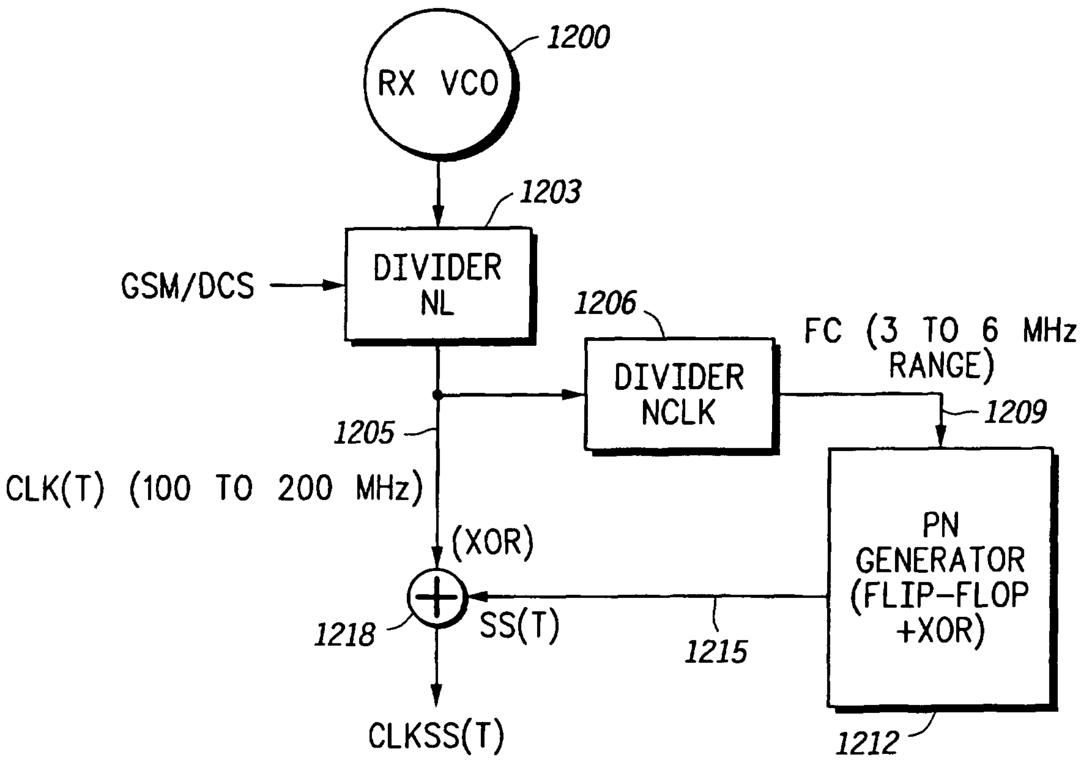


FIG.12

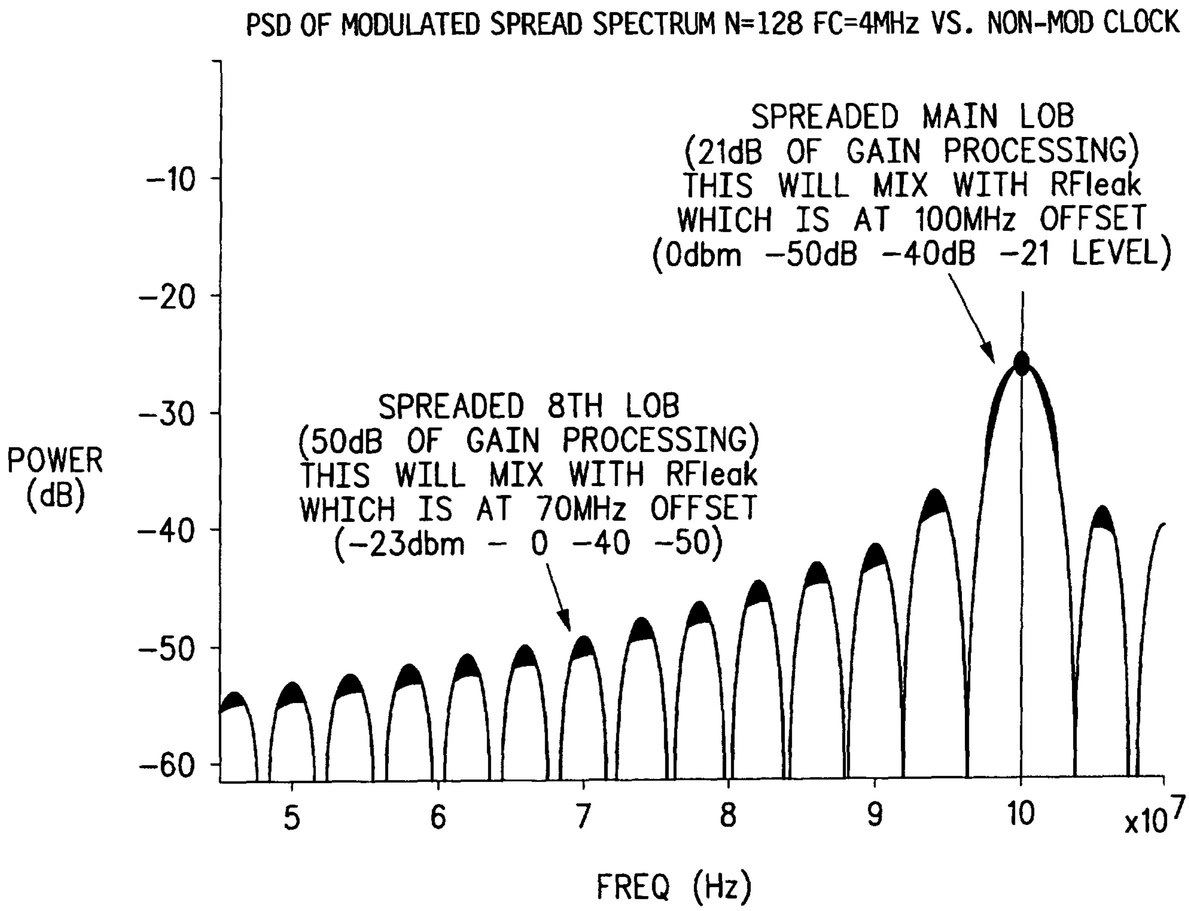
PSD OF MODULATED SPREAD SPECTRUM N=128 FC=4MHz VS. NON-MOD CLOCK
SPREADED MAIN LOB
(21dB OF GAIN PROCESSING)
THIS WILL MIX WITH RFleak
WHICH IS AT 100MHz OFFSET
(0dbm −50dB −40dB −21 LEVEL)
SPREADED 8TH LOB
(50dB OF GAIN PROCESSING)
THIS WILL MIX WITH RFleak
WHICH IS AT 70MHz OFFSET
(−23dbm − 0 −40 −50)
POWER
(dB)
−10
−20
−30
−40
−50
−60
5
6
7
8
9
10
x10^7
FREQ (Hz)

*FIG.13*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 9601006 A